(19) Europäisches Patentamt
European Patent Office
Office européen des brevets

(11) EP 0 734 464 B1

(12) **FASCICULE DE BREVET EUROPEEN**

(45) Date de publication et mention de la délivrance du brevet:
**11.03.1998 Bulletin 1998/11**

(21) Numéro de dépôt: **95903396.0**

(22) Date de dépôt: **13.12.1994**

(51) Int Cl.[6]: **C23C 16/44**, C23C 16/32, C23C 16/04, C04B 35/00

(86) Numéro de dépôt international:
**PCT/FR94/01453**

(87) Numéro de publication internationale:
**WO 95/16803 (22.06.1995 Gazette 1995/26)**

(54) **PROCEDE DE DENSIFICATION DE SUBSTRATS POREUX**

VERFAHREN ZUM ABDICHTEN PORÖSER SUBSTRATE

POROUS SUBSTRATE DENSIFICATION METHOD

(84) Etats contractants désignés:
**DE GB SE**

(30) Priorité: **16.12.1993 FR 9315176**

(43) Date de publication de la demande:
**02.10.1996 Bulletin 1996/40**

(73) Titulaire: **SOCIETE EUROPEENNE DE PROPULSION**
**92150 Suresnes (FR)**

(72) Inventeurs:
- **REY, Jacques**
  **F-33700 Merignac (FR)**
- **CHARVET, Jean-Luc**
  **F-33160 Saint-Médard-en-Jalles (FR)**
- **ROBIN-BROSSE, Christian**
  **F-33185 Le Haillan (FR)**
- **DELPERIER, Bernard**
  **F-33127 MARTIGNAS SUR JALLES (FR)**
- **MINET, Jacky**
  **F-33160 Saint-Médard-en-Jalles (FR)**

(74) Mandataire: **Joly, Jean-Jacques et al**
**Cabinet Beau de Loménie**
**158, rue de l'Université**
**75340 Paris Cédex 07 (FR)**

(56) Documents cités:
**WO-A-87/04733** **DE-A- 4 129 102**

- **SOLAR CELLS, vol.19, no.3-4, Janvier 1987, LAUSANNE CH pages 189 - 201 C.R. DICKSON 'SAFTY PROCEDURES USED DURING THE MANUFACTURING OF AMORPHOUS SILICON SOLAR CELLS'**

EP 0 734 464 B1

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

**Description**

La présente invention concerne la densification de substrats poreux par infiltration chimique en phase vapeur de carbure de silicium.

Un domaine d'application de l'invention est celui de la réalisation de pièces en matériau composite thermostructural à matrice au moins partiellement réalisée en carbure de silicium. De telles pièces sont notamment utilisables en aéronautique, ou dans le domaine spatial ou encore dans celui de la friction en raison de leurs propriétés mécaniques, qui les rendent aptes à constituer des éléments de structure, et de leur capacité à conserver ces propriétés à des températures élevées.

La réalisation de pièces en matériau composite thermostructural comprend généralement la réalisation d'un substrat ou préforme en fibres réfractaires, notamment en fibres de carbone ou en fibres céramiques, et la densification de la préforme par le matériau constitutif de la matrice.

Des procédés de densification d'un substrat poreux par une matrice en carbure de silicium sont bien connus.

L'invention concerne le procédé de densification par infiltration chimique en phase vapeur. Selon ce procédé, le substrat à densifier est placé dans une chambre d'infiltration. Une phase gazeuse réactive comprenant généralement un mélange de méthyltrichlorosilane (MTS) et d'hydrogène est admise dans la chambre. Les conditions de température et de pression sont réglées pour permettre à la phase gazeuse de diffuser dans la porosité du substrat jusqu'au coeur de celui-ci et de former un dépôt de carbure de silicium par décomposition du MTS en présence de l'hydrogène agissant comme réducteur :

$$CH_3SiCl_3 \xrightarrow{H_2} SiC + 3HCl$$

L'infiltration chimique en phase vapeur requiert un contrôle particulier des conditions opératoires pour permettre une densification du substrat jusqu'au coeur de celui-ci de façon aussi homogène et complète que possible. En effet, dans des conditions mal contrôlées, il risque de se former un dépôt massif en surface qui obture rapidement la porosité interne du substrat et empêche toute densification à coeur. L'infiltration chimique en phase vapeur se distingue donc dans sa mise en oeuvre des procédés de dépôt chimique en phase vapeur utilisés pour former des revêtements de surface.

Différents procédés d'infiltration chimique en phase vapeur sont connus, à savoir les procédés à gradient de température et/ou à gradient de pression et le procédé isotherme et isobare.

Avec les procédés à gradient de température et/ou de pression, on établit entre les surfaces du substrat exposées à la phase gazeuse réactive et des parties internes du substrat éloignées des surfaces exposées des différences de température et/ou de pression qui favorisent la formation de la matrice d'abord dans les parties internes du substrat. La densification progresse vers les surfaces exposées, aboutissant ainsi à un résultat relativement homogène.

Le procédé à gradient de température est mis en oeuvre en chauffant le substrat soit indirectement par contact de surfaces internes du substrat avec un noyau chauffé par induction, soit par couplage inductif direct lorsque la nature du substrat le permet. Ce procédé est limité dans son application à des substrats de forme simple.

Quant au procédé à gradient de pression, il nécessite l'établissement d'un flux forcé à travers le substrat et demande donc un appareillage adapté à la forme de celui-ci.

Or, la durée des cycles d'infiltration chimique en phase vapeur fait qu'à l'échelle industrielle il est nécessaire d'utiliser un procédé permettant de densifier simultanément, à l'intérieur d'une même chambre, plusieurs substrats dont les formes peuvent être différentes ou complexes.

On utilise alors le procédé isotherme isobare en cherchant à régler la température et la pression dans l'enceinte à des valeurs optimales pour assurer une densification à coeur et aussi homogène que possible dans des substrats de formes et d'épaisseurs diverses, ceci dans l'ensemble du volume utile de la chambre.

Un tel procédé pour l'infiltration chimique en phase vapeur de carbure de silicium a été décrit dans le document FR-A-2 401 888. La plage de température recommandée est comprise entre la valeur de la température de décomposition commençante du MTS et cette valeur augmentée de 150°C, de préférence augmentée de 100°C, c'est-à-dire une plage d'environ 800 à 950°C, de préférence 800 à 900°C.

La pression totale dans la chambre recommandée est de préférence comprise entre plusieurs centaines et plusieurs milliers de Pa.

Une installation permettant la mise en oeuvre industrielle de ce procédé est décrite dans le document FR-A-2 594 119. La phase gazeuse réactionnelle pénétrant dans la chambre est préchauffée pour être portée à la température

régnant dans celle-ci avant contact avec le substrat à densifier. Le préchauffage est réalisé en faisant passer la phase gazeuse réactionnelle au contact de plateaux de préchauffage situés dans la chambre. La phase gazeuse résiduelle constituée par le reliquat de phase gazeuse réactionnelle et les produits gazeux de réaction est extraite hors de la chambre par pompage.

En dépit d'un contrôle précis des conditions d'infiltration, le procédé isotherme isobare conduit à la formation d'un sur-dépôt à la surface des substrats. Au cours d'un processus de densification, il est donc usuel de retirer au moins une fois les substrats partiellement densifiés de la chambre d'infiltration afin de procéder à un écroûtage, c'est-à-dire un usinage de surface permettant de réouvrir complètement l'accès à la porosité interne résiduelle. Ces opérations intermédiaires allongent encore la durée des cycles de densification.

La présente invention a pour objet de proposer un procédé d'infiltration chimique en phase vapeur de carbure de silicium plus particulièrement adapté à une mise en oeuvre au stade industriel.

Plus précisément, la présente invention vise à fournir un procédé permettant d'augmenter la vitesse de densification tout en conservant une densification homogène du substrat poreux jusqu'au coeur de celui-ci.

L'invention a aussi pour objet de fournir un procédé assurant une meilleure reproductibilité des caractéristiques de densification, que ce soit pour différents substrats ou pour des mises en oeuvre dans différentes installations.

Ces différents objets sont atteints grâce à un procédé du type comprenant la mise en place du substrat dans une chambre d'infiltration, l'introduction d'une phase gazeuse réactionnelle comprenant du méthyltrichlorosilane et de l'hydrogène dans la chambre d'infiltration où règnent des conditions de température et de pression d'infiltration prédéterminées, le préchauffage de la phase gazeuse entrant dans la chambre d'infiltration afin de la porter en température avant contact de la phase gazeuse avec le substrat, et l'extraction hors de la chambre d'infiltration de la phase gazeuse résiduelle comprenant le reliquat de phase gazeuse réactionnelle et des produits de réaction gazeux, procédé selon lequel, conformément à l'invention, l'infiltration est réalisée à une température comprise entre 960°C et 1 050°C sous une pression totale au plus égale à 25 kPa et la concentration de la phase gazeuse résiduelle en espèces siliciées est abaissée en sortie de la chambre d'infiltration.

De préférence, l'infiltration est réalisée à une température comprise entre 1 000°C et 1 030°C.

Une des caractéristiques de l'invention réside dans le niveau relativement élevé de la température d'infiltration. En effet, dans le document FR-A-2 401 888 déjà cité, la plage de température préconisée est de 800°C à 950°C, c'est-à-dire une température peu supérieure à la température de décomposition commençante du MTS.

Or, la déposante a pu mettre en évidence qu'une température plus élevée peut être utilisée, en combinaison avec le préchauffage de la phase gazeuse réactionnelle sans introduire d'inconvénient. En effet, il n'en résulte pas l'apparition d'un gradient de densification plus élevé, tandis que la vitesse de densification, qui est liée à la température, s'en trouve accrue.

En outre, le processus de densification se révèle très peu sensible à de faibles variations de température dans la plage choisie, ce qui permet de garantir une bonne reproductibilité du procédé à l'échelle industrielle.

Selon une autre caractéristique du procédé conforme à l'invention, l'infiltration est réalisée sous une pression totale relativement basse, au plus égale à 25 kPa et de préférence comprise entre 7 kPa et 12 kPa, et la concentration de la phase gazeuse résiduelle en espèces silicées est abaissée en sortie de la chambre d'infiltration.

Pour une capacité de pompage donnée, l'exigence d'une pression totale relativement basse dans la chambre d'infiltration peut interdire une dilution importante de la phase gazeuse réactionnelle par un gaz neutre, sauf à réduire considérablement les débits de MTS et de $H_2$, donc la vitesse de densification. Ainsi, la présence d'espèces gazeuses silicées avec une concentration élevée en sortie de la chambre d'infiltration favorise la formation de condensats indésirables, voire même potentiellement dangereux sur les parois de canalisations en aval de la chambre. L'abaissement de la concentration de la phase gazeuse résiduelle en espèces gazeuses siliciées réduit le risque de formation de tels dépôts.

Cet abaissement de concentration peut être réalisé par injection d'un gaz neutre dans la phase gazeuse résiduelle immédiatement en sortie de la chambre d'infiltration. Il peut être réalisé aussi en faisant passer la phase gazeuse résiduelle au contact et/ou au travers d'un ou plusieurs substrats dans une zone d'appauvrissement située en aval de la chambre d'infiltration.

L'invention sera mieux comprise à la lecture de la description faite ci-après à titre indicatif mais non limitatif, en référence aux dessins annexés sur lesquels :

- la figure 1 est une vue schématique en coupe d'une installation d'infiltration chimique en phase vapeur permettant la mise en oeuvre du procédé selon l'invention ;
- la figure 2 illustre une variante de réalisation d'une installation d'infiltration chimique en phase vapeur permettant la mise en oeuvre du procédé selon l'invention ;
- la figure 3 illustre l'influence de la température sur la décomposition du MTS ; et
- les figures 4 et 5 illustrent la variation de vitesse de croissance de carbure de silicium en fonction de la température d'infiltration respectivement pour deux valeurs différentes du rapport a entre débit de $H_2$ et débit de MTS introduits

dans la chambre d'infiltration.

Le procédé conforme à l'invention peut être mis en oeuvre sur différents types de substrats poreux. Ceux-ci pourront consister en des préformes fibreuses ayant une forme proche de celle de pièces composites à réaliser. Les fibres de la préforme, par exemple des fibres en carbone ou des fibres céramiques, pourront être préalablement revêtues d'une couche destinée à former une interphase entre les fibres et la matrice en carbure de silicium, par exemple une couche de carbone pyrolytique ou de nitrure de bore comme décrit dans le document EP 0 172 082. La préforme fibreuse pourra même avoir été partiellement densifiée, par exemple par du carbone pyrolytique, la poursuite de la densification par la matrice en carbure de silicium donnant une matrice mixte (ou biphasée) carbone/carbure de silicium.

Le procédé selon l'invention peut être mis en oeuvre dans une installation telle que représentée par la figure 1.

Cette installation est dérivée de celle décrite dans le document FR-A-2 594 119 déjà cité.

L'installation d'infiltration comprend une chambre d'infiltration 30 délimitée par un induit en graphite 32. L'induit 32 est entouré d'un inducteur métallique 34 avec interposition d'un isolant thermique 36. L'ensemble est logé à l'intérieur d'une enceinte métallique étanche 38.

L'induit 32 a la forme d'un cylindre d'axe vertical fermé à sa partie inférieure par un fond 32a et à sa partie supérieure par un couvercle amovible 32b. A l'intérieur de la chambre 30, les préformes à densifier par le carbure de silicium, éventuellement maintenues dans un outillage, sont placées sur un plateau perforé 40. Le plateau 40 peut tourner autour d'un axe vertical confondu avec celui de la chambre 30. La rotation est commandée par un moteur (non représenté) couplé au plateau par un arbre 42 traversant le fond 32a.

La phase gazeuse réactionnelle contenant le MTS et l'hydrogène provenant de réserves (non représentées) est introduite dans la chambre 30 par une canalisation d'amenée 44 qui traverse l'enceinte 38 et aboutit à la partie supérieure de la chambre à travers le couvercle 32b. La phase gazeuse réactionnelle pénétrant dans la chambre 30 est forcée à circuler au contact de plateaux de préchauffage. Ceux-ci, formés de plaques perforées superposées 46, permettent de porter rapidement la phase gazeuse réactionnelle à la température régnant dans la chambre.

L'extraction de la phase gazeuse résiduelle est réalisée à travers une ou plusieurs canalisations 48 qui sont reliées à la partie inférieure de la chambre 30 par un passage annulaire 50 entourant l'arbre 42.

Le volume situé autour de l'induit 32 à l'intérieur de l'enceinte 38 est balayé en permanence par un gaz neutre, tel que de l'azote. Celui-ci provient d'une réserve 72 et est amené par une canalisation 52, à travers une vanne 74. Il est extrait de l'enceinte 38 par une canalisation 54. Un tampon de gaz neutre est ainsi formé autour de la chambre 30.

A l'extérieur de l'enceinte, les canalisations 48 et 54 se rejoignent pour former une canalisation unique 56 raccordée à un dispositif de pompage 60.

Une unité de contrôle 62 reçoit des signaux représentatifs de la température et de la pression dans la chambre fournis par des capteurs respectifs 64, 66. Ce dernier est logé dans l'enceinte 38, à l'extérieur de la chambre 30, l'enceinte et la chambre étant en équi-pression. L'unité de contrôle 62 commande un générateur 68 qui fournit le courant d'alimentation de l'inducteur 34 de manière à maintenir la température dans la chambre 30 à la valeur prédéterminée pour l'opération d'infiltration chimique en phase vapeur. L'unité de contrôle 62 est en outre reliée à la vanne 74 pour commander le débit d'azote introduit par la canalisation 52 afin de maintenir la pression dans la chambre 30 à la valeur désirée.

Selon une caractéristique du procédé, l'unité de contrôle 62 commande le générateur 68 de manière à maintenir la température dans la chambre 30 à une valeur comprise entre 960°C et 1 050°C, de préférence entre 1 000°C et 1 030°C.

La figure 3 illustre la variation de pression partielle de MTS en fonction de la température dans une enceinte dans laquelle est admise une phase gazeuse constituée de MTS et de $H_2$. Le rapport $\alpha$ entre débit de $H_2$ et débit de MTS est égal à 7, et la pression dans l'enceinte est égale à 10 kPa.

La décomposition du MTS commence à environ 800°C et est complète au-delà d'environ 1 050°C.

La figure 4 illustre la variation du taux de croissance R du dépôt de carbure de silicium en fonction de la température, pour un rapport $\alpha = 5$ et une pression totale égale à 10 kPa.

Aux températures les moins élevées (domaine A), environ entre 800°C et 950°C, la vitesse de croissance du dépôt augmente avec la température. La cinétique du dépôt est limitée, donc contrôlée, par une étape du processus de réaction à la surface de la préforme.

Aux températures les plus élevées (domaine B), au-delà de 1 050°C environ, la cinétique de dépôt est contrôlée par diffusion dans une couche limite qui constitue l'interface entre la phase gazeuse réactionnelle dynamique et la surface du substrat. La cinétique du dépôt devient peu dépendante de la température, mais la diffusion dans la couche limite dépend de l'épaisseur de cette couche, épaisseur qui varie localement en fonction des conditions aérodynamiques de diffusion dans la préforme.

Afin d'assurer l'homogénéité du dépôt aussi bien dans une préforme donnée que dans tout le volume de la chambre 30, il est donc nécessaire de rechercher une condition de dépôt contrôlée par une réaction de surface et non pas une condition de dépôt contrôlée par une diffusion dans une couche limite.

Au stade industriel, il est avantageux de se placer non seulement dans le domaine cinétique régi par une réaction de surface, mais également à la plus haute température autorisée dans ce domaine afin de bénéficier des vitesses de densification les plus élevées possibles.

Il est également avantageux de favoriser le contrôle de la cinétique par une étape du processus de réaction de surface qui limite le plus le risque de diminution de la cinétique au fur et à mesure que la phase gazeuse réactionnelle diffuse dans la porosité d'une préforme ou circule dans l'ensemble de la chambre de réaction. Il faut alors éviter que la cinétique de dépôt soit contrôlée par la quantité locale présente d'une espèce source, ce qui conduirait à favoriser des phénomènes d'appauvrissement de la phase gazeuse réactionnelle, mais plutôt à rechercher un contrôle de la cinétique par une espèce issue de la réaction, en l'occurrence le chlorure d'hydrogène HCl.

Or, la courbe de la figure 4 fait apparaître l'existence d'un minimum local qui se situe, dans le sens des températures croissantes, juste avant le domaine où la cinétique est régie par diffusion dans une couche limite. Cette zone particulière C, où la cinétique reste encore régie par une réaction de surface, correspond à une limitation de la réaction par présence d'HCl adsorbé en surface de la préforme. En se plaçant dans cette zone d'inhibition, une cinétique de densification élevée est atteinte tout en favorisant l'homogénéité du dépôt aussi bien dans la préforme que dans l'ensemble de la chambre de réaction.

Cette zone C correspond à une plage de température d'environ 960°C à environ 1 050°C, dans le cas de la figure 4. Il en est de même dans le cas de la figure 5 qui diffère de celui de la figure 4 par un rapport $\alpha$ égal à 10 au lieu de 5.

Au vu des courbes des figures 4 et 5, la recherche de la température d'infiltration la plus élevée possible, sans aborder le domaine B où la cinétique est régie par diffusion dans une couche limite, conduit à choisir de préférence une température d'infiltration entre 1 000°C et 1 030°C.

Pour que l'effet décrit ci-dessus soit produit, il est favorable que la phase gazeuse réactionnelle soit portée à la température d'infiltration voulue avant sa diffusion dans la préforme. Ceci est réalisé par le préchauffage de la phase gazeuse au moyen des plateaux de préchauffage 46, ceux-ci étant en permanence à la température régnant dans la chambre 30 telle que régulée par l'unité de contrôle 62.

De plus, les courbes des figures 4 et 5 montrent que, dans la zone d'inhibition C, une variation locale de température a peu d'effet sur le taux de croissance du dépôt (contrairement à la zone A). Or, il est en pratique très difficile de maintenir la température précisément à la valeur prédéterminée en tout point de la préforme et de la chambre d'infiltration. Des différences locales sont inévitables, par exemple du fait du masquage du rayonnement par la préforme ou de la limitation des effets de convection aux basses pressions. Le choix du domaine de température, conformément à l'invention, présente donc, en outre, l'avantage de rendre la cinétique de dépôt peu dépendante de la température tout en restant en régime de réaction de surface.

Selon une autre caractéristique du procédé, la pression totale dans la chambre d'infiltration 30 est maintenue à une valeur au plus égale à 25 kPa, de préférence comprise entre 7 kPa et 12 kPa, pour favoriser la diffusion de la phase gazeuse réactionnelle au coeur de la préforme à densifier.

Pour une capacité de pompage donnée, cette pression relativement faible peut s'avérer incompatible avec une dilution importante de la phase gazeuse réactionnelle par un gaz neutre.

Aussi, la phase gazeuse résiduelle extraite de l'enceinte contient une proportion relativement élevée d'espèces siliciées. Outre le MTS non décomposé, des espèces telles que chlorosilanes, hydrogénochlorosilanes et organosilanes peuvent être présentes. Ces sous-produits de la décomposition du MTS peuvent se polycondenser sur des parois froides en aval de la chambre d'infiltration et donner naissance à des condensats instables.

La déposante a pu mettre en évidence que le contact de ces condensats avec l'air induit leur hydrolyse rapide. Il se forme ainsi à la surface du condensat une couche passivante de silice hydratée inerte, qui joue un rôle de barrière de diffusion vis-à-vis de l'oxygène. Toutefois, sous cette couche, la transformation du condensat n'est que partielle avec formation de composés instables tels que chlorosiloxanes ou silanols. Si le dépôt de condensat est important, ce phénomène de transformation partielle n'atteint pas le coeur du condensat.

Le même mécanisme d'oxydation est possible si la condensation s'effectue sur une paroi déjà revêtue de silice hydratée lors de cycles d'infiltration précédents. La passivation superficielle s'effectue alors partiellement avant même tout contact avec l'air.

Une destruction brutale de la couche superficielle passivante conduit à une inflammation du condensat, car les composés instables sous-jacents se décomposent violemment au contact de l'air. Ces réactions sont très exothermiques et ont ainsi pour conséquence l'échauffement du coeur du condensat non affecté qui dégage alors lui-même des vapeurs inflammables.

Si un condensat passivé superficiellement est maintenu sur les parois lors des cycles suivants, celui-ci continue à se transformer progressivement et devient d'autant plus instable. Seul un séjour à l'air d'une très longue durée pourrait permettre une passivation définitive.

Ainsi, en présence de tels condensats sur les parois d'une canalisation, toute manipulation par un opérateur comporte un risque important de brûlures. En effet, à tout moment, un apport d'énergie aussi anodin que le frottement d'un outil ou d'un chiffon ou l'enlèvement de la couche passivante peut suffire à provoquer une auto-inflammation de la paroi.

Il est donc utile de prévenir la formation de ces condensats et à cette fin d'abaisser la concentration de la phase gazeuse résiduelle issue de la chambre 30 en espèces siliciées. Dans l'installation de la figure 1, ceci est réalisé par injection d'un gaz de dilution en sortie de la chambre 30. L'injection est réalisée par une canalisation 70 qui aboutit dans le passage 50 immédiatement à l'extérieur de l'enceinte 38. La canalisation 70 est alimentée en gaz neutre, par exemple de l'azote provenant de la réserve 72 à travers une vanne 76 commandée par l'unité de contrôle 62. Bien entendu, la capacité du dispositif de pompage 60 et la commande de celui-ci sont adaptées pour permettre, en dépit de cette injection supplémentaire, de maintenir la pression dans la chambre à la valeur voulue.

Différents essais ont été effectués avec l'installation de la figure 1 afin de vérifier l'efficacité de la dilution de la phase gazeuse résiduelle pour la prévention de formation de condensats indésirables sur les parois des canalisations de sortie 48, 56. Ces essais ont été effectués pour différentes valeurs de la pression totale $P_t$ dans la chambre 30, différentes valeurs du rapport R entre débit $H_2$ et débit MTS dans la phase gazeuse réactionnelle, différentes valeurs du débit total D de la phase gazeuse réactionnelle et différentes valeurs du facteur $F_d$ de dilution par l'azote de la phase gazeuse résiduelle. Les valeurs de R et D sont données en comparaison avec des valeurs de référence $R_1$ et $D_1$. Le facteur de dilution $F_d$ est donné par le rapport entre le débit d'azote $D(N_2)$ injecté par la canalisation 70 et la somme totale du débit d'azote $D(N_2)$ et des débits des gaz D(MTS) et $D(H_2)$ injectés par la canalisation d'amenée 44.

$$F_d = \frac{D(N_2)}{D(MTS + H_2) + D(N_2)}$$

Le tableau ci-après donne les résultats observés quant à la présence et à la nature de condensats instables sur les parois des canalisations de sortie.

| Pression totale $P_t$ (kPa) | Rapport R $D(H_2)/D$ (MTS) | Débit total D | $F_d$ | Présence condensats | Observations |
|---|---|---|---|---|---|
| 15 | $R_1$ | $D_1$ | 0,70-0,75 | NON | |
| 10<br>8,5<br>8,5 | $R_1$<br>$R_3$ (>$R_1$)<br>$R_2$ (<$R_1$) | $D_1$<br>$D_1$<br>$D_2$ (<$D_1$) | 0,60-0,65<br>0,55-0,60<br>0,65-0,70 | OUI<br>OUI<br>OUI | Pâte blanchâtre instable |
| 8,5 | $R_1$ | $D_3$ (>$D_1$) | 0,90-0,95 | NON | |
| 2<br>2 | $R_3$ (>$R_1$)<br>$R_1$ | $D_1$<br>$D_2$ (<$D_1$) | 0,45-0,50<br>0,60-0,65 | OUI<br>OUI | Liquide visqueux brun très instable |
| 2 | $R_2$ (<$R_1$) ) | $D_3$ (>$D_1$) | 0,85-0,90 | NON | |

Ces résultats montrent que le facteur de dilution doit être au moins égal à 0,7.

La figure 2 illustre un autre mode de réalisation de moyens permettant d'abaisser la concentration de la phase gazeuse résiduelle en espèces siliciées.

L'installation de la figure 2 diffère de celle de la figure 1, d'une part, par la suppression des moyens d'amenée d'un gaz de dilution en sortie de la chambre et, d'autre part, par l'aménagement d'une zone d'appauvrissement immédiatement en amont de la sortie de l'enceinte. Les éléments communs aux installations des figures 1 et 2 portent les mêmes références.

La zone d'appauvrissement 80 est située à la partie inférieure de l'enceinte 38, entre le plateau porte-charge 40 et un plateau de chargement utile 82 situé au-dessus de celui-ci. Les plateaux 40 et 82 sont constitués de deux plaques perforées parallèles, par exemple en graphite, maintenues espacées l'une de l'autre par des entretoises 84, également en graphite.

La zone d'appauvrissement ainsi délimitée par les plateaux 40 et 82 est garnie de substrats fibreux, sous forme de disques 84 disposés les uns au-dessus des autres. Les disques 84 sont maintenus légèrement espacés les uns des autres et espacés des plateaux 40 et 82 par des entretoises 86 en graphite. Les disques 84 présentent des ouvertures 88 disposées en quinconce pour imposer un trajet sinueux à la phase gazeuse résiduelle entre la chambre 30 proprement dite, située au-dessus du plateau 82 et la sortie hors de l'enceinte 38.

Il règne dans la zone d'appauvrissement 80 les mêmes conditions de pression et de température que dans la chambre 30. La phase gazeuse résiduelle diffusant à travers les substrats 84 s'appauvrit en espèces réactives en donnant naissance à un dépôt de carbure de silicium. Ainsi, les substrats 84 se densifient et la phase gazeuse résiduelle extraite de l'enceinte 38 est appauvrie en espèces siliciées. Suivant leur niveau de densification, les substrats 84 sont

changés ou non après une opération complète d'infiltration.

Des essais ont été effectués en utilisant pour les substrats 84 trois disques en feutre de fibres de carbone ayant une épaisseur de 3 mm et un taux volumique de fibres de 6% (pourcentage du volume apparent du disque effectivement occupé par les fibres). Une augmentation du rendement de la réaction de 50% a été observée, par rapport au cas où aucune zone d'appauvrissement n'est prévue. En d'autres termes, le pourcentage d'espèces siliciées qui ont été combinées avant extraction de la phase gazeuse résiduelle hors de l'enceinte est augmenté de 50%. Il en est résulté une diminution suffisante de la concentration en espèces siliciées non combinées pour éviter la formation de condensats instables.

On notera que la zone d'appauvrissement ne saurait être assimilée à une extension de la zone utile d'infiltration, permettant d'envisager la densification de préformes pour la réalisation de pièces en matériau composite dans la zone d'appauvrissement.

En effet, d'une part, il existe des contraintes quant aux formes, dimensions et porosité des substrats disposés dans la zone d'appauvrissement.

D'autre part, la phase gazeuse résiduelle pénétrant dans la zone d'appauvrissement ne présente plus nécessairement la composition convenable pour réaliser un dépôt de carbure de silicium ayant la microtexture souhaitée et/ou avec une uniformité de densification souhaitée.

Les substrats densifiés dans la zone d'appauvrissement sont destinés à être sacrifiés.

Bien entendu, les deux moyens envisagés ci-dessus pour abaisser la concentration de la phase résiduelle en espèces siliciées peuvent être combinés en munissant l'installation de la figure 2 d'une conduite d'injection de gaz de dilution comme dans l'installation de la figure 1.

## Revendications

1. Procédé de densification isotherme et isobare d'un substrat poreux par infiltration chimique en phase vapeur de carbure de silicium, comprenant la mise en place du substrat dans une chambre d'infiltration, l'introduction d'une phase gazeuse réactionnelle comprenant du méthyltrichlorosilane et de l'hydrogène dans la chambre d'infiltration où règnent des conditions de température et de pression d'infiltration prédéterminées, le préchauffage de la phase gazeuse entrant dans la chambre d'infiltration afin de la porter en température avant contact avec le substrat, et l'extraction hors de la chambre d'infiltration de la phase gazeuse résiduelle comprenant le reliquat de phase gazeuse réactionnelle et des produits de réaction gazeux,
   caractérisé en ce que l'infiltration est réalisée à une température comprise entre 960°C et 1 050°C sous une pression totale au plus égale à 25kPa et la concentration de la phase gazeuse résiduelle en espèces siliciées est abaissée en sortie de la chambre d'infiltration.

2. Procédé selon la revendication 1, caractérisé en ce que l'infiltration est réalisée à une température comprise entre 1 000°C et 1 030°C.

3. Procédé selon l'une quelconque des revendications 1 et 2, caractérisé en ce que l'infiltration est réalisée sous une pression totale dans la chambre d'infiltration comprise entre 7 kPa et 12 kPa.

4. Procédé selon l'une quelconque des revendications 1 à 3, caractérisé en ce que l'abaissement de la concentration de la phase gazeuse résiduelle en espèces siliciées est réalisé par dilution de celle-ci par un gaz neutre immédiatement en sortie de la chambre d'infiltration.

5. Procédé selon la revendication 4, caractérisé en ce que le rapport entre le débit de gaz neutre injecté et la somme des débits de la phase gazeuse réactionnelle et du gaz neutre injecté est au moins égal à 0,7.

6. Procédé selon l'une quelconque des revendications 1 à 3, caractérisé en ce que l'abaissement de la concentration de la phase gazeuse résiduelle en espèces gazeuses siliciées est réalisé par un passage de celle-ci au contact et/ou au travers d'au moins un substrat dans une zone d'appauvrissement située en aval de la chambre d'infiltration.

## Patentansprüche

1. Verfahren zur isothermen und isobaren Verdichtung eines porösen Substrats durch chemische Infiltration in der Gasphase von Siliciumcarbid, aufweisend das Anbringen des Substrats in einer Infiltrationskammer, das Zuführen einer Reaktionsgasphase, die Methyltrichlorsilan und Wasserstoff enthält, in die Infiltrationskammer, in der vorbestimmte Temperatur- und Druckbedingungen der Infiltration herrschen, das Vorwärmen der in die Infiltrationskammer eintretenden Gasphase, um sie vor Berührung mit dem Substrat auf eine Temperatur zu bringen, und das Ausbringen der verbleibenden Gasphase, die den Rest der Reaktionsgasphase und die Produkte der Gasreaktion enthält, aus der Infiltrationskammer,
dadurch gekennzeichnet, daß die Infiltration bei einer Temperatur zwischen 960°C und 1050°C unter einem Gesamtdruck von höchstens 25 kPa ausgeführt wird, und die Konzentration der verbleibenden Gasphase an siliciumhaltigen Verbindungen beim Auslaß aus der Infiltrationskammer verringert wird.

**2.** Verfahren nach Anspruch 1, dadurch gekennzeichnet, daß die Infiltration bei einer Temperatur zwischen 1000°C und 1030°C ausgeführt wird.

**3.** Verfahren nach Anspruch 1 oder 2, dadurch gekennzeichnet, daß die Infiltration unter einem Gesamtdruck in der Infiltrationskammer zwischen 7 kPa und 12 kPa ausgeführt wird.

**4.** Verfahren nach einem der Ansprüche 1 bis 3, dadurch gekennzeichnet, daß die Verringerung der Konzentration der verbleibenden Gasphase an siliciumhaltigen Verbindungen durch Verdünnung dieser mit einem neutralen Gas direkt beim Auslaß aus der Infiltrationskammer ausgeführt wird.

**5.** Verfahren nach Anspruch 4, dadurch gekennzeichnet, daß das Verhältnis zwischen der Menge des eingeblasenen neutralen Gases und der Summe der Mengen der Reaktionsgasphase und des eingeblasenen neutralen Gases mindestens gleich 0,7 ist.

**6.** Verfahren nach einem der Ansprüche 1 bis 3, dadurch gekennzeichnet, daß die Verringerung der Konzentration der verbleibenden Gasphase an gasförmigen siliciumhaltigen Verbindungen durch einen Durchgang derselben in Berührung mit mindestens einem Substrat und/oder durch mindestens ein Substrat hindurch in einem stromab von der Infiltrationskammer gelegenen Verarmungsbereich ausgeführt wird.

## Claims

**1.** A constant temperature and constant pressure method of densifying a porous substrate by chemical vapor infiltration of silicon carbide, the method comprising placing the substrate in an infiltration chamber, injecting a reaction gas containing methyltrichlorosilane and hydrogen into the infiltration chamber in which predetermined infiltration temperature and pressure conditions prevail, preheating the gas entering the infiltration chamber so as to bring it up to temperature before making contact with the substrate, and extracting the residual gas from the infiltration chamber, which gas includes the remainder of the reaction gas and the products of gaseous reaction,
the method being characterized in that infiltration is performed at a temperature lying in the range 960°C to 1050°C under a total pressure of not more than 25 kPa, and the concentration of silicon-containing species in the residual gas is lowered at the outlet from the infiltration chamber.

**2.** A method according to claim 1, characterized in that infiltration is performed at a temperature lying in the range 1000C° to 1030°C.

**3.** A method according to any one of claims 1 and 2, characterized in that infiltration is performed at a total pressure in the infiltration chamber lying in the range 7 kPa to 12 kPa.

**4.** A method according to any one of claims 1 to 3, characterized in that the concentration of silicon-containing species in the residual gas is lowered by diluting the residual gas with an inert gas immediately on leaving the infiltration chamber.

**5.** A method according to claim 4, characterized in that the ratio between the flow rate of injected inert gas and the sum of the flow rates of reaction gas plus injected inert gas is not less than 0.7.

**6.** A method according to any one of claims 1 to 3, characterized in that the lowering of the concentration of silicon-containing gaseous species in the residual gas is achieved by passing the residual gas in contact with and/or through at least one substrate in a dilution zone situated downstream from the infiltration chamber.

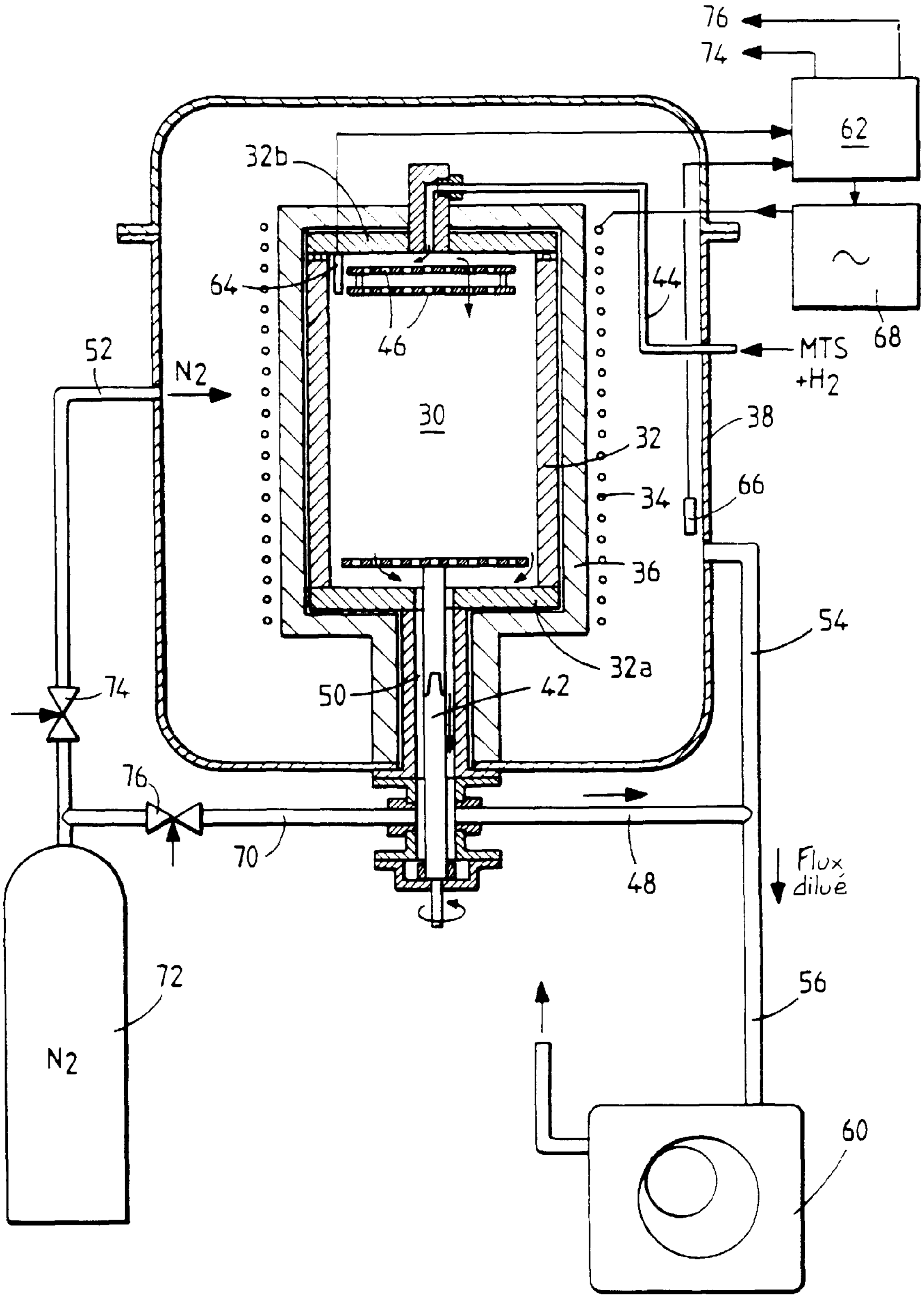
76
74
62
32b
64
46
44
MTS
+H2
68
52
N2
30
32
38
34
66
36
54
32a
50
42
74
76
70
48
Flux
dilué
72
N2
56
60

FIG.1

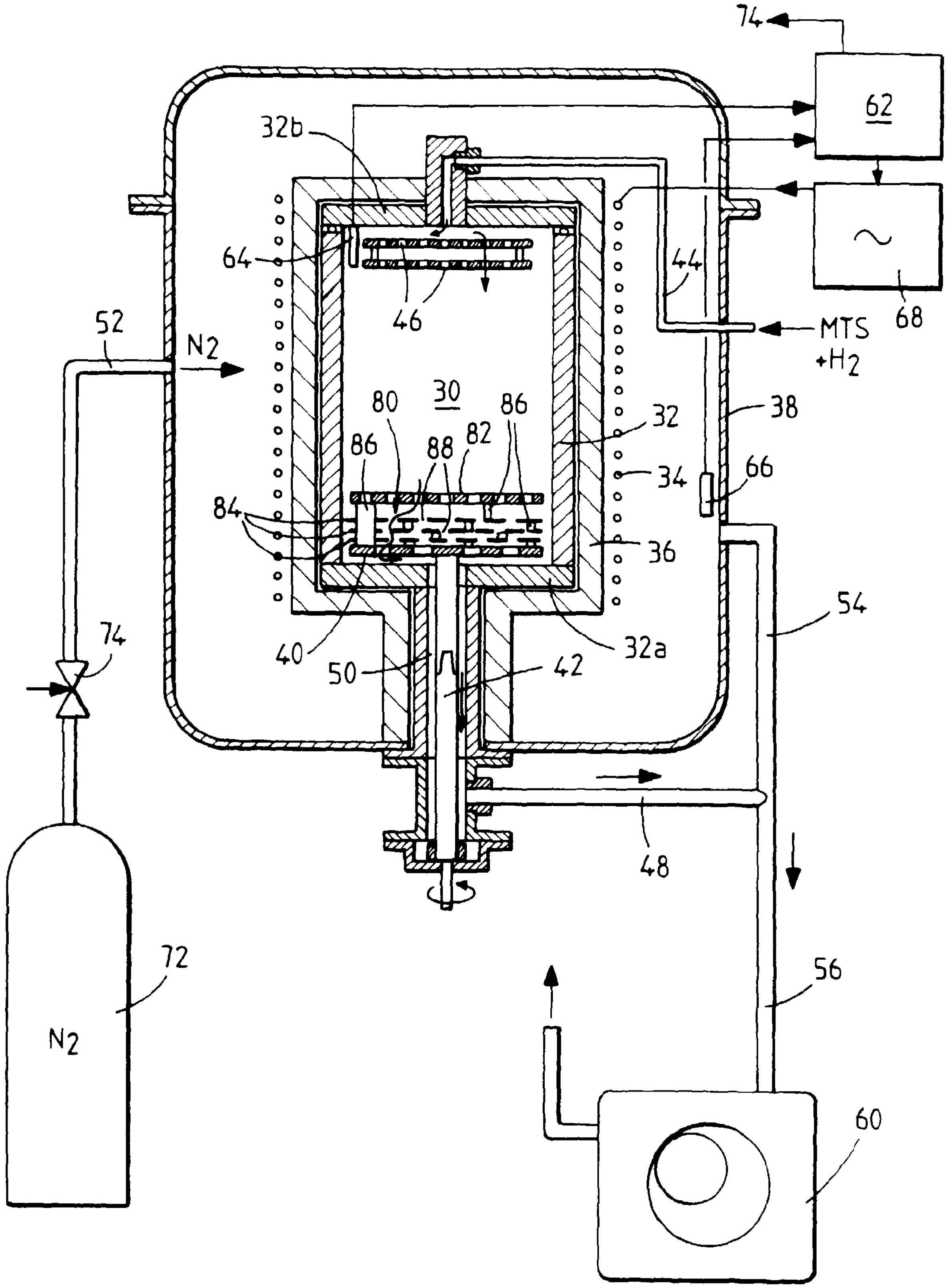
74
62
68
32b
64
46
44
MTS
+H2
52
N2
30
80
86
88
82
86
32
38
34
66
84
36
54
40
50
42
32a
74
48
56
72
N2
60

FIG. 2

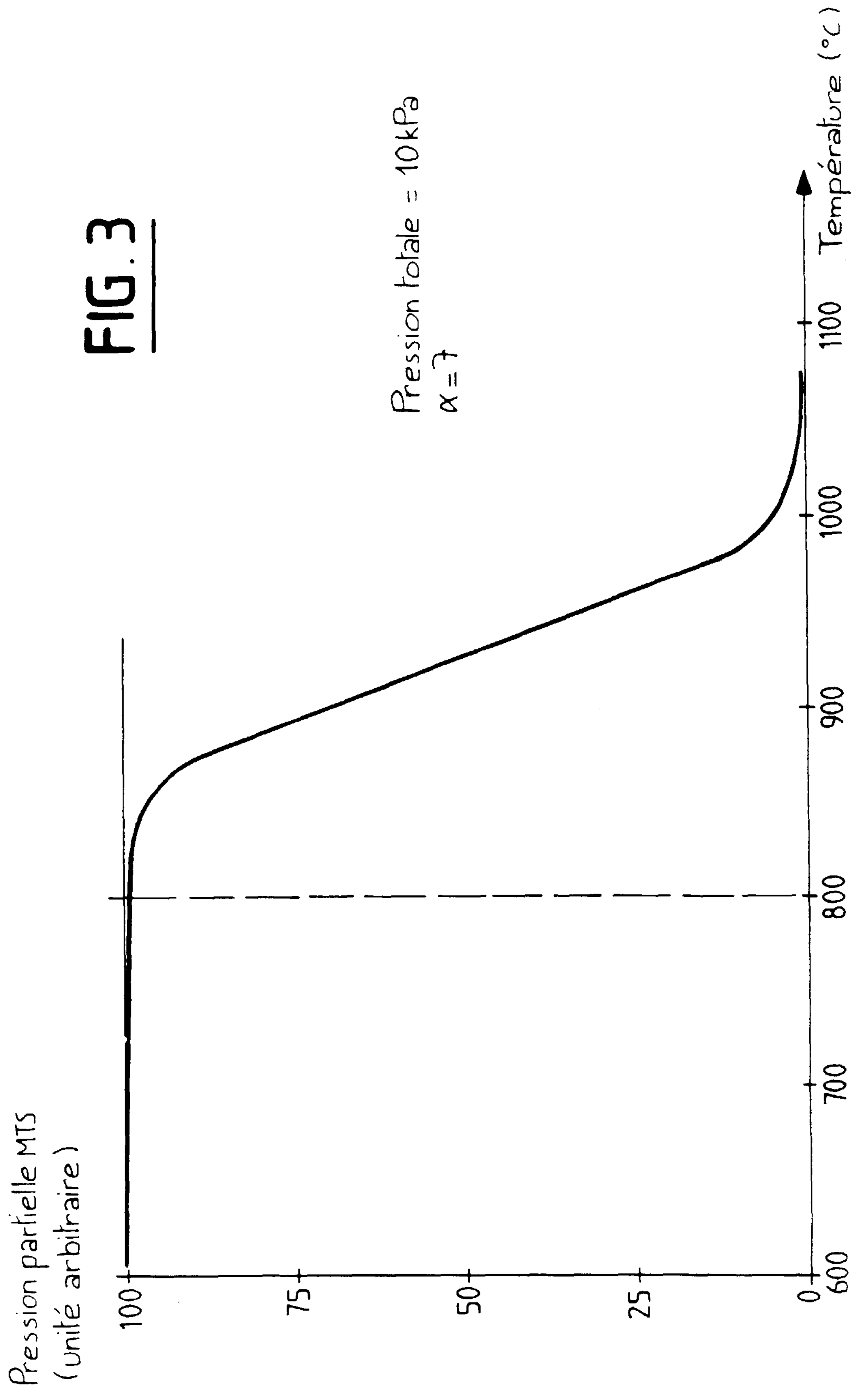
Pression partielle MTS
(unité arbitraire)
100
75
50
25
0
600
700
800
900
1000
1100
Température (°C)
Pression totale = 10 kPa
α = 7

FIG. 3

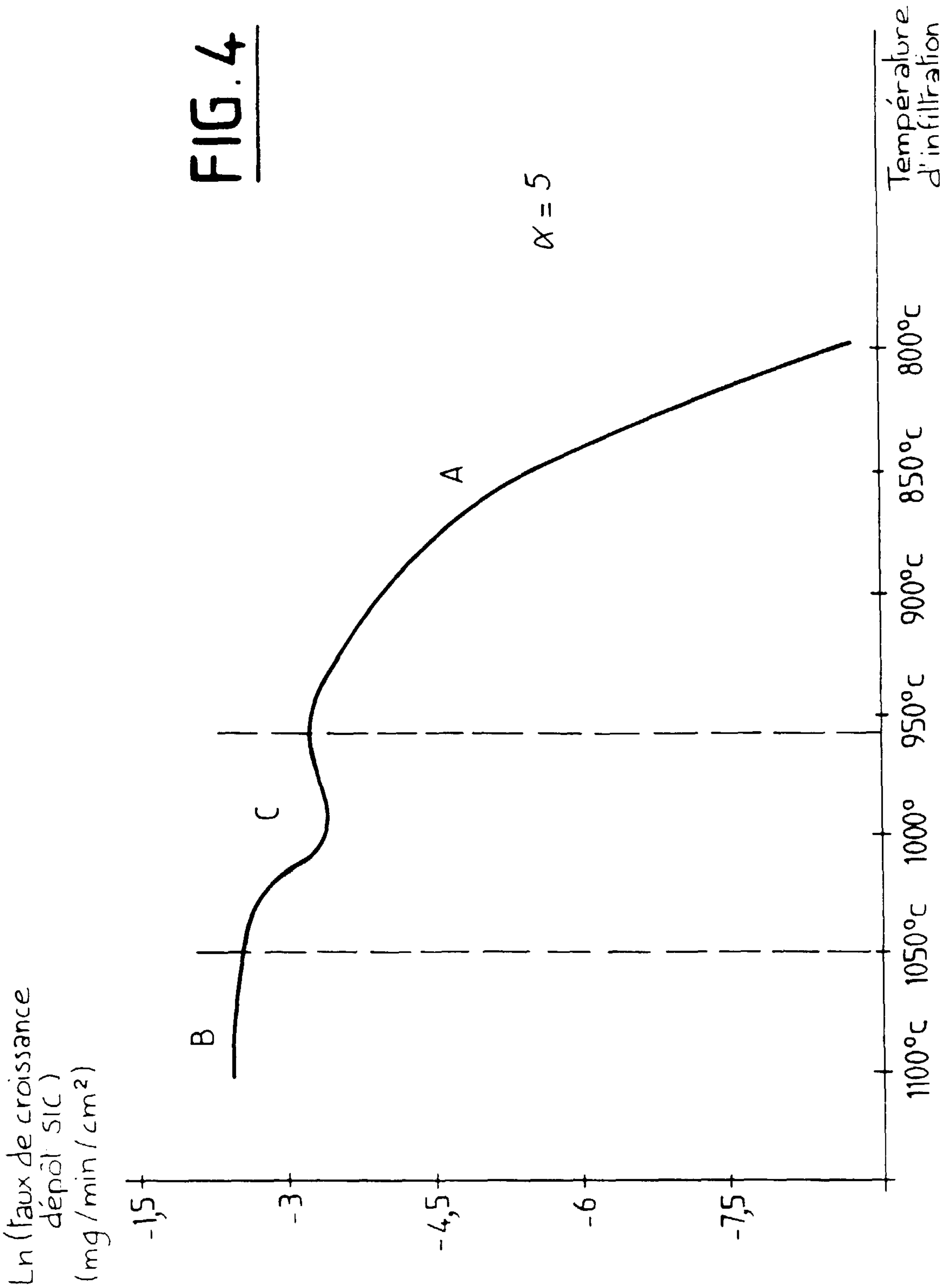
Ln (taux de croissance
dépôt SiC)
(mg / min / cm²)
-1,5
-3
-4,5
-6
-7,5
1100°c
1050°c
1000°
950°c
900°c
850°c
800°c
Température
d'infiltration
α = 5
A
B
C

FIG. 4

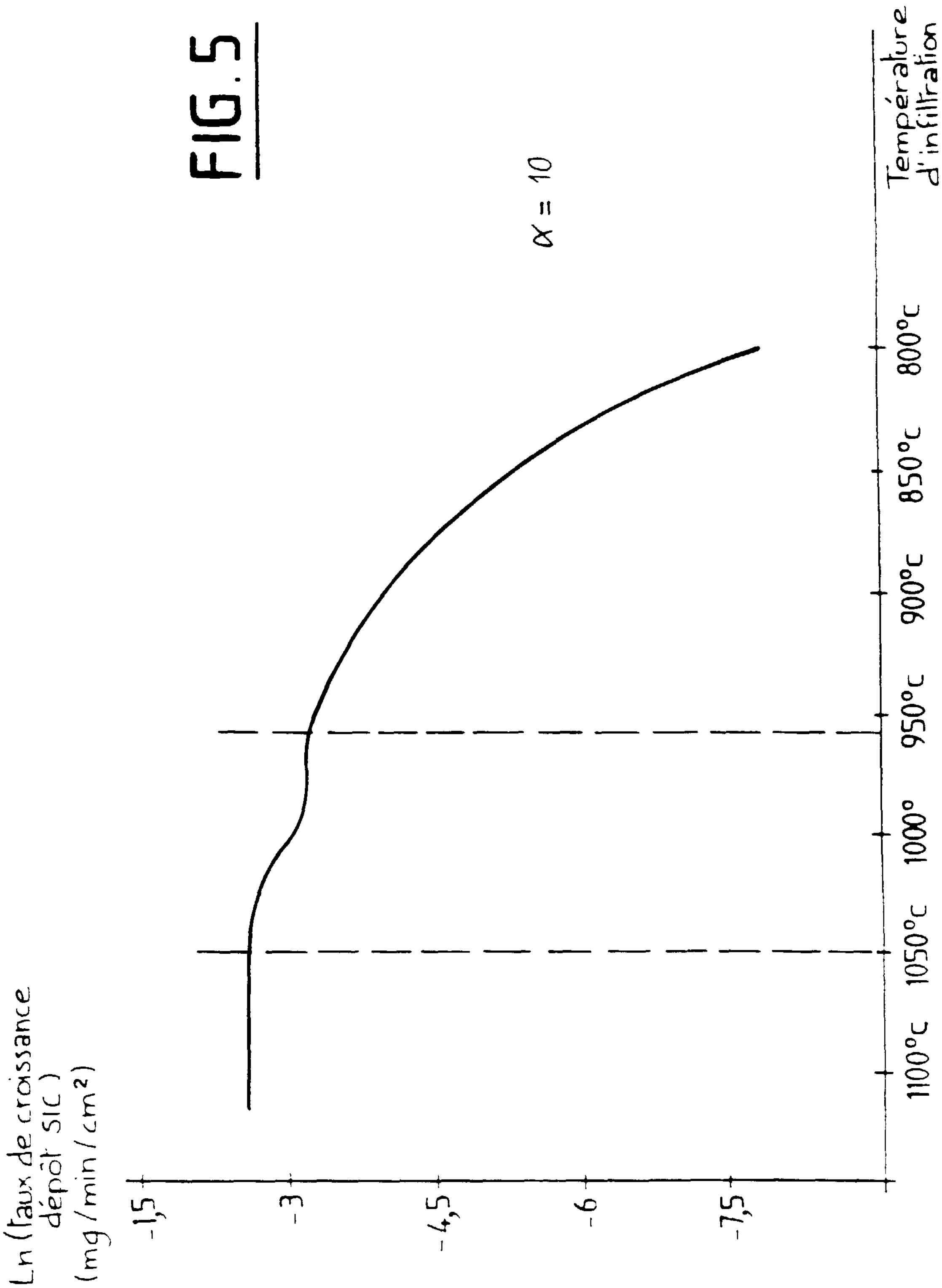

Ln (taux de croissance dépôt SIC) (mg/min/cm²)
-1,5
-3
-4,5
-6
-7,5
1100°c
1050°c
1000°
950°c
900°c
850°c
800°c
Température d'infiltration
α = 10


FIG. 5